# DEMANDE DE BREVET EUROPEEN

(11) **EP 4 524 806 A1**
(43) Date de publication de la demande: **19.03.2025**
(21) Numéro de dépôt: 24195330.6
(22) Date de dépôt: 20.08.2024
(51) Int. Cl.: G06F 30/20, G06N 3/08

(54) **PROCEDE DE DETERMINATION D'UN RISQUE D'ECHEC D'ATTERRISSAGE**

(30) Priorité: 22.08.2023 FR 2308848
(71) Demandeur: Airbus Operations (S.A.S.), 31060 Toulouse Cedex 9 (FR)
(72) Inventeur: BOURRET, Thierry, 31060 TOULOUSE (FR); MULLER, Jean, 31060 TOULOUSE (FR); RONCERAY, Lilian, 31060 TOULOUSE (FR); CAHINGT, Nils, 31060 TOULOUSE (FR)
(74) Mandataire: Cabinet Le Guen Maillet

(57) **Abrégé**

Un procédé de détermination d'un risque d'échec d'atterrissage d'un aéronef sur un lieu d'atterrissage s'appuie sur une table de référence construite en : effectuant (102) une sélection d'un jeu de valeurs de M variables représentatives de conditions d'atterrissage indépendantes de turbulences potentielles, de manière uniforme entre une valeur minimale et une valeur maximale de chaque variable ; réalisant (104) un nombre P de simulations en boucle fermée en appliquant des conditions de turbulences aléatoires, à partir du jeu de valeurs des M variables ; calculant (106) une moyenne et un écart-type de paramètres de toucher au sol à partir des P simulations en boucle fermée ; et en complétant (108) la table de référence à chaque itération pour un nombre N de jeux de valeurs des M variables. Ensuite, la table de référence est utilisée (112) pour déterminer le risque d'échec d'atterrissage, au regard de conditions d'atterrissage envisagées.

## Description

### DOMAINE TECHNIQUE

La présente invention concerne un procédé et un système pour déterminer un risque d'échec d'atterrissage d'un aéronef sur un lieu d'atterrissage.

### ETAT DE LA TECHNIQUE ANTERIEURE

Il existe des outils pour déterminer un risque d'échec d'atterrissage, comme par exemple utilisés dans des systèmes d'atterrissage automatique dans des aéronefs. Ces outils traitent par simulations en boucle fermée des variables représentatives de conditions d'atterrissage auxquelles s'ajoute un modèle de turbulences destiné à reproduire des effets de turbulences rencontrées à l'atterrissage. Il en ressort des estimations de paramètres de toucher au sol (« touchdown parameters » en anglais) qui, comparés à des valeurs limites d'acceptabilité, définissent un risque d'échec d'atterrissage.

Chacune de ces variables est caractérisée par une distribution de probabilité. Par exemple, la vitesse moyenne de vent latéral suit une distribution de probabilité gaussienne. Par exemple encore, la longueur de piste suit une distribution de probabilité spécifique entre 1500 m et 4500 m. Il est particulièrement important de noter que, dans ces outils, la distribution de probabilité de chaque variable est établie vis-à-vis d'un retour d'expérience sur toute une flotte d'aéronefs.

Il est alors possible pour ces outils de déterminer un risque moyen, sur toute la flotte d'aéronefs, d'échec d'atterrissage sur l'ensemble des lieux d'atterrissage possibles pour la flotte d'aéronefs.

Il peut toutefois être souhaitable de déterminer un risque d'échec d'atterrissage plus spécifiquement pour un aéronef sur un lieu d'atterrissage particulier dans des conditions d'atterrissage particulières. Auquel cas, il est aussi souhaitable de fournir une solution qui soit rapide à utiliser.

### EXPOSE DE L'INVENTION

Il est ainsi proposé ici un procédé de détermination d'un risque d'échec d'atterrissage d'un aéronef sur un lieu d'atterrissage particulier, dans lequel un système sous forme de circuiterie électronique construit une table de référence comme suit : effectuer une sélection d'un jeu de valeurs de M variables représentatives de conditions d'atterrissage indépendantes de turbulences potentielles à l'atterrissage ; réaliser un nombre P de simulations en boucle fermée en appliquant des conditions de turbulences aléatoires selon un modèle prédéfini de turbulences, à partir du jeu de valeurs des M variables qui a été sélectionné ; calculer une moyenne et un écart-type de paramètres de toucher au sol à partir des P simulations en boucle fermée ; compléter la table de référence en ajoutant une ligne à la table de référence, chaque ligne stockant la moyenne et l'écart-type de chaque paramètre de toucher au sol, ainsi que le jeu de valeurs des M variables qui a permis d'obtenir ladite moyenne et ledit écart-type ; réitérer pour un nombre N de jeux de valeurs des M variables, les valeurs de chaque variable étant choisies de manière uniforme entre une valeur minimale et une valeur maximale de ladite variable. Le procédé est tel qu'il comporte en outre : utiliser la table de référence pour déterminer le risque d'échec d'atterrissage de l'aéronef sur le lieu d'atterrissage particulier, au regard de conditions d'atterrissage envisagées, le risque d'échec d'atterrissage étant une probabilité qu'au moins un des paramètres de toucher au sol franchisse une limite autorisée pour ledit paramètre de toucher au sol.

Ainsi, un risque d'échec d'atterrissage peut être spécifiquement déterminé pour un aéronef sur un lieu d'atterrissage particulier dans des conditions d'atterrissage particulières. De plus, la construction de la table de référence permet de rapidement déterminer un tel risque d'échec d'atterrissage pour différents lieux d'atterrissage (distingués les uns des autres dans ladite table de référence) et conditions d'atterrissage particulières, du fait que les simulations en boucle fermée sont réalisées en amont, lors de la construction de la table de référence.

Dans une première approche, utiliser la table de référence comporte : utiliser la table de référence pour réaliser une phase d'apprentissage d'un modèle d'apprentissage profond, l'apprentissage étant tel que les conditions enregistrées dans la table de référence sont saisies en entrée du modèle d'apprentissage profond afin de prédire les valeurs correspondantes de moyenne et d'écart-type pour chaque paramètre de toucher au sol. Et dans une phase d'utilisation du modèle d'apprentissage profond après la phase d'apprentissage, le procédé comporte : obtenir les conditions envisagées à l'atterrissage, exprimées par des valeurs correspondantes des M variables ; injecter les conditions envisagées à l'atterrissage en entrée du modèle d'apprentissage profond ; récupérer en sortie du modèle d'apprentissage profond des valeurs attendues de moyenne et d'écart-type pour chaque paramètre de toucher au sol ; déterminer le risque d'échec d'atterrissage pour l'aéronef sur le lieu d'atterrissage particulier, en utilisant la moyenne et l'écart-type, pour chaque paramètre de toucher au sol, récupérés.

Dans une deuxième approche, utiliser la table de référence comporte : obtenir les conditions envisagées à l'atterrissage, exprimées par des valeurs correspondantes des M variables ; rechercher un jeu de conditions enregistré dans la table de référence le plus proche des conditions envisagées à l'atterrissage ; récupérer de la table de référence des valeurs attendues de moyenne et d'écart-type pour chaque paramètre de toucher au sol, qui ont été enregistrées en correspondance du jeu de conditions le plus proche des conditions envisagées à l'atterrissage ; et déterminer le risque d'échec d'atterrissage pour l'aéronef sur le lieu d'atterrissage particulier, en utilisant la moyenne et l'écart-type, pour chaque paramètre de toucher au sol, récupérés.

Dans une troisième approche, utiliser la table de référence comporte : obtenir les conditions envisagées à l'atterrissage, exprimées par des valeurs correspondantes des M variables ; rechercher des jeux de conditions enregistrés dans la table de référence qui sont les plus proches des conditions envisagées à l'atterrissage ; récupérer un jeu de valeurs attendues de moyenne et d'écart-type qui a été enregistré en correspondance de chaque jeu de conditions parmi lesdits jeux de conditions les plus proches des conditions envisagées à l'atterrissage ; réaliser une interpolation des jeux de valeurs attendues de moyenne et d'écart-type récupérés ; et déterminer un risque d'échec d'atterrissage pour l'aéronef sur le lieu d'atterrissage particulier, en utilisant la moyenne et l'écart-type, pour chaque paramètre de toucher au sol, qui résultent de l'interpolation réalisée.

Dans un mode de réalisation particulier, le procédé comporte en outre : éliminer des conditions qui ont le moins d'influence sur les paramètres de toucher au sol par rapport aux autres conditions, pour réduire N à Q, et remplacer la table de référence obtenue avec les N jeux de valeurs des M variables par une nouvelle table de référence obtenue avec les Q jeux de valeurs des M variables.

Dans un mode de réalisation particulier, le procédé comporte en outre : analyser des relations de dépendance des paramètres de toucher au sol avec les M variables ; déterminer quelle combinaison linéaire des M variables influence le plus les paramètres de toucher au sol ; et remplacer la table de référence obtenue avec les N j eux de valeurs des M variables par une nouvelle table de référence obtenue avec Q jeux de la combinaison linéaire des M variables, et dans lequel la table de référence est utilisée en appliquant la même combinaison linéaire sur les conditions envisagées à l'atterrissage.

Dans un mode de réalisation particulier, le procédé comporte en outre : déterminer quelles variables parmi les M variables influencent le plus les paramètres de toucher au sol ; et remplacer la table de référence obtenue avec les N jeux de valeurs des M variables sélectionnés de manière uniforme par une nouvelle table de référence obtenue en augmentant un panel de valeurs des variables qui influencent le plus les paramètres de toucher au sol et en diminuant un panel de valeurs des variables qui influencent le moins les paramètres de toucher au sol.

Dans un mode de réalisation particulier, le procédé est implémenté dans le cadre d'une assistance au pilotage d'aéronef, pour effectuer une sélection de lieu d'atterrissage parmi des lieux d'atterrissage candidats.

Dans un mode de réalisation particulier, le procédé est implémenté dans le cadre d'une assistance au pilotage d'aéronef, pour surveiller une évolution de risque d'échec d'atterrissage à destination.

Il est aussi proposé ici un système configuré pour déterminer un risque d'échec d'atterrissage d'un aéronef sur un lieu d'atterrissage particulier, le système étant sous forme de circuiterie électronique, la circuiterie électronique étant configurée pour construire une table de référence comme suit : effectuer une sélection d'un jeu de valeurs de M variables représentatives de conditions d'atterrissage indépendantes de turbulences potentielles à l'atterrissage ; réaliser un nombre P de simulations en boucle fermée en appliquant des conditions de turbulences aléatoires selon un modèle prédéfini de turbulences, à partir du jeu de valeurs des M variables qui a été sélectionné ; calculer une moyenne et un écart-type de paramètres de toucher au sol à partir des P simulations en boucle fermée ; compléter la table de référence en ajoutant une ligne à la table de référence, chaque ligne stockant la moyenne et l'écart-type de chaque paramètre de toucher au sol, ainsi que le jeu de valeurs des M variables qui a permis d'obtenir ladite moyenne et ledit écart-type ; réitérer pour un nombre N de jeux de valeurs des M variables, les valeurs de chaque variable étant choisies de manière uniforme entre une valeur minimale et une valeur maximale de ladite variable. Et la circuiterie électronique étant en outre configurée pour utiliser la table de référence pour déterminer le risque d'échec d'atterrissage de l'aéronef sur le lieu d'atterrissage particulier, au regard de conditions d'atterrissage envisagées, le risque d'échec d'atterrissage étant une probabilité qu'au moins un des paramètres de toucher au sol franchisse une limite autorisée pour ledit paramètre de toucher au sol.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un algorithme de construction d'une table de référence permettant de déterminer un risque d'échec d'atterrissage ;
[Fig. 2] illustre schématiquement un exemple d'agencement matériel de système adapté pour construire et /ou utiliser la table de référence ;
[Fig. 3] illustre schématiquement un algorithme d'utilisation de la table de référence pour déterminer un risque d'échec d'atterrissage, selon un premier mode de réalisation ;
[Fig. 4] illustre schématiquement un algorithme d'utilisation de la table de référence pour déterminer un risque d'échec d'atterrissage, selon un deuxième mode de réalisation ;
[Fig. 5] illustre schématiquement un algorithme d'utilisation de la table de référence pour déterminer un risque d'échec d'atterrissage, selon un troisième mode de réalisation ;
[Fig. 6] illustre schématiquement un algorithme d'assistance au pilotage d'aéronef permettant d'effectuer une sélection de lieu d'atterrissage ;
[Fig. 7] illustre schématiquement un algorithme d'assistance au pilotage d'aéronef permettant de surveiller une évolution de risque d'échec d'atterrissage ; et
[Fig. 8] illustre schématiquement, en vue de côté, un aéronef équipé d'un système d'assistance au pilotage.

### EXPOSE DETAILLE DE MODES DE REALISATION

Comme détaillé par la suite, un système est spécifiquement configuré pour construire et utiliser une table de référence afin de permettre de déterminer un risque d'échec d'atterrissage pour un aéronef particulier sur une piste d'atterrissage particulière.

La construction de la table de référence est, dans au moins un mode de réalisation, faite dans une première partie du système, par exemple chez un avionneur ; et l'utilisation de la table de référence est faite dans une deuxième partie du système, par exemple à bord d'un aéronef ou dans des locaux d'une compagnie aérienne, pour déterminer le risque d'échec d'atterrissage pour l'aéronef sur une piste d'atterrissage particulière.

La construction de la table de référence est, dans au moins un autre mode de réalisation, faite dans une première partie du système, par exemple chez un avionneur ; l'utilisation de la table de référence est aussi faite dans cette première partie du système pour obtenir un modèle d'apprentissage profond dérivé de la table de référence, et c'est ce modèle d'apprentissage profond qui est alors utilisé dans une deuxième partie du système, par exemple à bord d'un aéronef ou dans des locaux d'une compagnie aérienne, pour déterminer le risque d'échec d'atterrissage pour l'aéronef sur une piste d'atterrissage particulière.

La construction de la table de référence et son utilisation pour déterminer le risque d'échec d'atterrissage pour un aéronef particulier sur une piste d'atterrissage particulière sont, dans encore au moins un autre mode de réalisation, faites dans un même dispositif, par exemple dans un même système informatique.

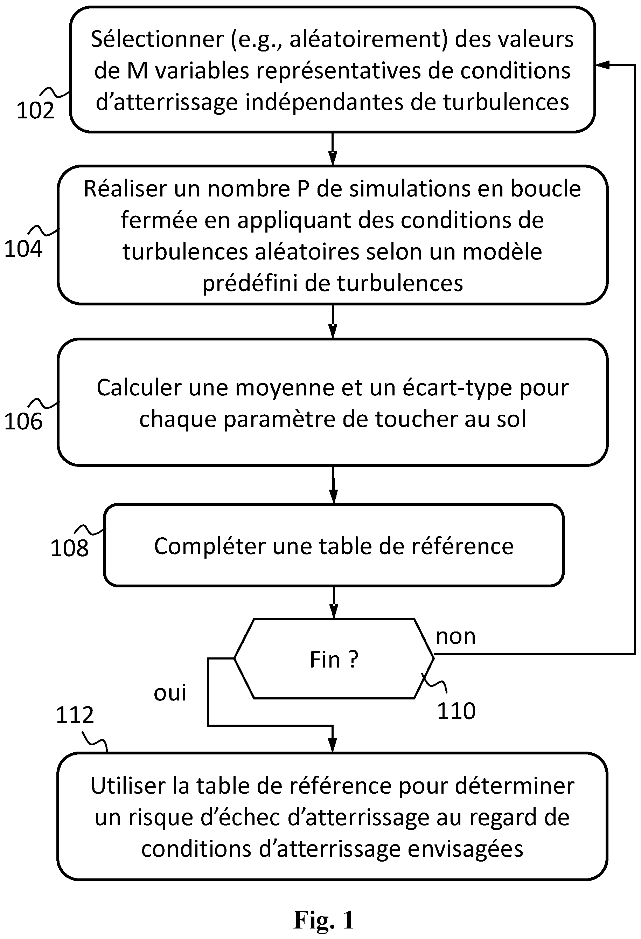

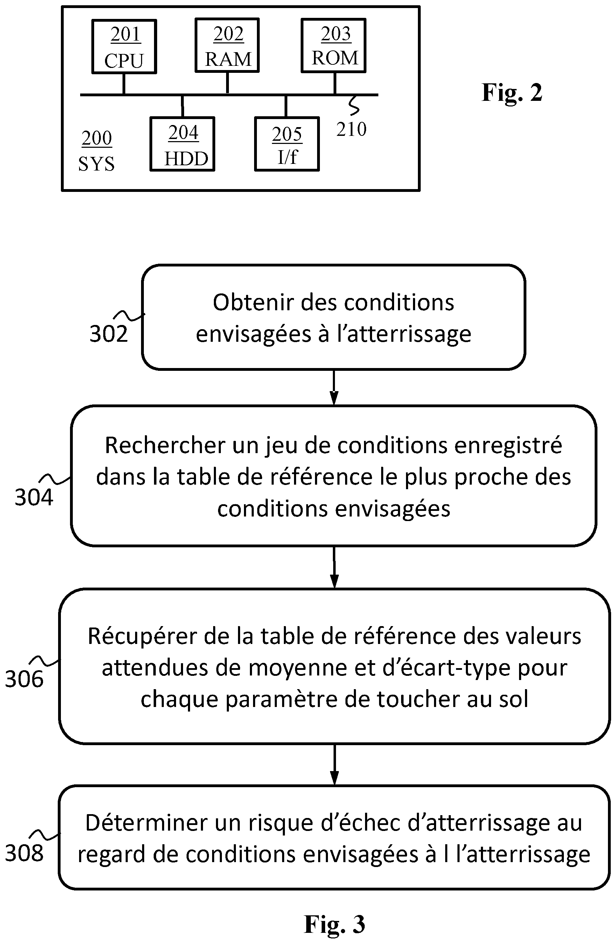

La Fig. 1 illustre schématiquement un algorithme de construction d'une table de référence permettant de déterminer un risque d'échec d'atterrissage pour un aéronef sur une piste d'atterrissage d'un aéroport. L'algorithme de la Fig. 1 est implémenté par un système sous forme de circuiterie électronique, dont un exemple d'agencement est présenté ci-après en relation avec la Fig. 2.

Dans une étape 102, le système effectue une sélection d'un jeu de valeurs de M variables représentatives de conditions d'atterrissage indépendantes de turbulences potentielles à l'atterrissage. Dans un mode de réalisation particulier, la sélection du jeu de valeurs des M variables est faite aléatoirement. Dans un autre mode de réalisation particulier, la sélection du jeu de valeurs des M variables est faite par maillage régulier, c'est-à-dire une répartition régulière des valeurs sélectionnées par variable.

Comme décrit ci-après, de multiples itérations vont être réalisées avec des jeux différents de valeurs de M variables. Les valeurs (panel de valeurs) de chaque variable sont choisies de manière uniforme entre une valeur minimale et une valeur maximale de ladite variable. Ainsi, les distributions de probabilité des M variables ne sont pas établies vis-à-vis d'un retour d'expérience sur toute une flotte d'aéronefs. Cela permet d'avoir toutes les combinaisons possibles des variables M ce qui, en observant les données en service peut ne jamais arriver.

Dans un mode de réalisation particulier, les variables représentatives de conditions d'atterrissage incluent :
- vitesse moyenne de vent longitudinal ;
- vitesse moyenne de vent latéral ;
- poids de l'aéronef ;
- position du centre de gravité de l'aéronef ;
- variation de température, comparativement au standard ISA (« International Standard Atmosphère » en anglais) ;
- altitude de la piste d'atterrissage ;
- longueur de la piste d'atterrissage ;
- pente de la piste d'atterrissage ;
- pente de trajectoire de descente (« glide slope » en anglais) ;
- hauteur de point de référence de trajectoire de descente (« glide référence point height » en anglais) ;
- désalignement de moyen de guidage radioélectrique (« localizer » en anglais).

Ainsi, par exemple, M = 11.

Dans une étape 104, le système réalise un nombre P de simulations en boucle fermée en appliquant des conditions de turbulences aléatoires selon un modèle prédéfini de turbulences, à partir du jeu de valeurs des M variables qui a été sélectionné. Par exemple, P = 200. L'amplitude des turbulences dépend typiquement de la vitesse de vent mesurée à la tour de contrôle de l'aéroport (« tower wind », en anglais) qui, par exemple, dépend de la vitesse moyenne de vent longitudinal et latéral.

Dans une étape 106, le système calcule, d'après les P simulations en boucle fermée, une moyenne et un écart-type pour chaque paramètre d'un ensemble de paramètres de toucher au sol (« touchdown parameters » en anglais).

Dans un mode de réalisation particulier, les paramètres de toucher au sol sont :
- le positionnement du point de toucher au sol longitudinal (dans l'axe de la piste d' atterrissage),
- le positionnement du point de toucher au sol latéral (perpendiculaire à l'axe de la piste d' atterrissage),
- charge de train d'atterrissage à l'impact,
- angle d'inclinaison latérale (« bank angle » en anglais),
- la garde au sol de la partie arrière du fuselage au toucher,
- le dérapage latéral au toucher (« Side Slip » en anglais).

Dans une étape 108, le système complète une table de référence. A chaque itération (étapes 102 à 106), le système ajoute une ligne à la table de référence. Chaque ligne stocke la moyenne et l'écart-type de chaque paramètre de toucher au sol, ainsi que les conditions dans lesquelles ils ont été obtenus, c'est-à-dire les valeurs des M variables qui ont permis de les obtenir.

Dans une étape 110, le système détermine si un nombre suffisant d'entrées a été obtenu dans la table de référence. Par exemple, N = 35000 conditions différentes sont testées, à savoir N jeux de valeurs des M variables. Si tel est le cas, une étape 112 est effectuée ; sinon, l'étape 102 est réitérée avec une sélection (*e.g*., aléatoire) d'un nouveau jeu de valeurs des M variables, et donc de nouvelles conditions d'atterrissage (indépendamment de turbulences potentielles à l'atterrissage) sont sélectionnées. Les réitérations de l'étape 102 sont telles que les valeurs (panel de valeurs) de chaque variable sont choisies (*e.g*., aléatoirement) de manière uniforme entre une valeur minimale et une valeur maximale de ladite variable. Par exemple, pour simplifier les simulations en boucle fermée, un sous-ensemble discret des valeurs de chaque variable peut être utilisé (e.g., la valeur minimale, la valeur maximale et quelques valeurs intermédiaires).

Dans une étape 112, le système utilise la table de référence pour déterminer un risque d'échec d'atterrissage au regard de conditions d'atterrissage envisagées. Le risque d'échec d'atterrissage est une probabilité qu'au moins un des paramètres de toucher au sol franchisse une limite autorisée pour ledit paramètre de toucher au sol. Par exemple, un toucher au sol latéral excentré de plus de 21 mètres pour un train d'atterrissage extérieur (« outboard landing gear » en anglais) sur une piste d'atterrissage de largeur égale à 45 mètres.

La table de référence (ou un modèle d'apprentissage profond dérivé de la table de référence, comme détaillé ci-après) permet de déterminer rapidement le risque d'échec d'atterrissage, puisque les simulations en boucle fermée ont été réalisées en amont (pour construire la table de référence). Et pour déterminer un risque d'échec d'atterrissage spécifiquement pour de nouvelles conditions d'atterrissage, il suffit de réutiliser la table de référence, sans avoir à exécuter à nouveau les simulations en boucle fermée.

Des modes de réalisation d'une utilisation de la table de référence pour déterminer un tel risque d'échec d'atterrissage sont détaillés ci-après, plus particulièrement en relation avec les Figs. 3 à 7.

Dans un mode de réalisation particulier, le système analyse des relations de dépendance des paramètres de toucher au sol avec les M variables. Cette analyse peut être une analyse de corrélation, par exemple de type Pearson ou Spearman. Cette analyse peut être une analyse en composantes principales PCA (« Principal Components Analysis » en anglais). Cette analyse permet donc de réduire le nombre de conditions différentes testées en simulation en éliminant des conditions qui ont le moins d'influence (i.e., qui n'influencent pas, ou peu) sur les paramètres de toucher au sol (réduction de N à Q) par rapport aux autres conditions. Le système peut alors remplacer la table de référence obtenue avec les N conditions par une nouvelle table de référence obtenue en réitérant l'algorithme de la Fig. 1 avec les Q conditions.

Dans une variante, l'analyse permet au système de déterminer quelle combinaison linéaire des M variables (première composante principale) influence le plus les paramètres de toucher au sol. Le système peut alors remplacer la table de référence obtenue avec les N conditions par une nouvelle table de référence obtenue en réitérant l'algorithme de la Fig. 1 avec Q jeux de la combinaison linéaire des M variables. La table de référence doit alors être utilisée en appliquant la même combinaison linéaire sur des conditions envisagées à destination.

Dans une autre variante, l'analyse permet au système de déterminer quelles variables influencent le plus les paramètres de toucher au sol. Alors, plutôt que de choisir les valeurs de chaque variable de manière uniforme, le système peut réitérer l'algorithme de la Fig. 1 en augmentant le panel de valeurs des variables qui influencent le plus les paramètres de toucher au sol et en diminuant le panel de valeurs des variables qui influencent le moins les paramètres de toucher au sol.

La **Fig. 2** illustre schématiquement un exemple de plateforme matérielle adaptée pour implémenter le système, référencé SYS 200 sur la Fig. 2, sous forme de circuiterie électronique. Le système peut comporter plusieurs plateformes matérielles coopérant, par exemple une première telle plateforme matérielle servant à la construction de la table de référence et une deuxième telle plateforme matérielle servant à l'utilisation de la table de référence.

La plateforme matérielle comporte alors, reliés par un bus de communication 210 : un processeur ou CPU (« Central Processing Unit » en anglais) 201 ; une mémoire vive RAM (« Random Access Memory » en anglais) 202 ; une mémoire morte 203, par exemple de type ROM (« Read Only Memory » en anglais) ou EEPROM (« Electrically-Erasable Programmable ROM » en anglais) ou de type Flash ; une unité de stockage, telle qu'un disque dur HDD (« Hard Disk Drive » en anglais) 204, ou un lecteur de support de stockage, tel qu'un lecteur de cartes SD (« Secure Digital » en anglais) ; et un gestionnaire d'interfaces I/f 205.

Le gestionnaire d'interfaces I/f 205 permet à la plateforme matérielle d'interagir avec des périphériques, tels que des périphériques d'interface homme machine (saisie, affichage de résultats de simulation...) et/ou avec un réseau de communication.

Le processeur 201 est capable d'exécuter des instructions chargées dans la mémoire vive 202 à partir de la mémoire morte 503, d'une mémoire externe, d'un support de stockage (tel qu'une carte SD), ou d'un réseau de communication. Lorsque la plateforme matérielle est mise sous tension, le processeur 201 est capable de lire de la mémoire vive 202 des instructions et de les exécuter. Ces instructions forment un programme d'ordinateur causant l'implémentation, par le processeur 201, de tout ou partie des étapes et algorithmes décrits ici.

Tout ou partie des étapes et algorithmes décrits ici peut ainsi être implémenté sous forme logicielle par exécution d'un ensemble d'instructions par une machine programmable, par exemple un processeur de type DSP (« Digital Signal Processor » en anglais) ou un microcontrôleur, ou être implémenté sous forme matérielle par une machine ou un composant électronique (« chip » en anglais) dédié ou un ensemble de composants électroniques (« chipset » en anglais) dédié. D'une manière générale, le système SYS 200 comporte de la circuiterie électronique adaptée et configurée pour implémenter les étapes et algorithmes décrits ici.

Le système SYS 200 peut être constitué d'une unique plateforme matérielle telle que décrite ci-dessus, par laquelle la table de référence est construite et utilisée. Ainsi, le système SYS 200 peut être un système informatisé en place dans des locaux d'un avionneur ou d'une compagnie aérienne.

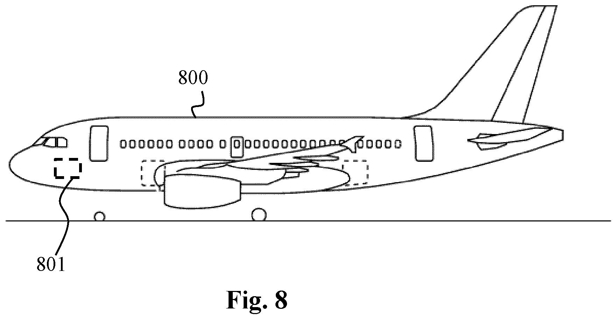

Le système SYS 200 peut être constitué d'un ensemble de telles plateformes matérielles. Une première plateforme matérielle, par laquelle la table de référence est construite, peut être un système informatisé en place dans des locaux d'un avionneur ou d'une compagnie aérienne ; et une deuxième plateforme matérielle, par laquelle la table de référence est utilisée, peut être un système embarqué dans un aéronef ou dans des locaux d'une compagnie aérienne. La table de référence est alors par exemple transmise depuis la première plateforme matérielle vers la deuxième plateforme matérielle par des moyens de communication. La **Fig. 8** illustre ainsi schématiquement, en vue de côté, un aéronef 800 embarquant une telle deuxième plateforme matérielle 801, par laquelle la table de référence est utilisée. La deuxième plateforme matérielle 801 est par exemple intégrée à l'avionique de l'aéronef 800.

La **Fig. 3** illustre schématiquement un algorithme d'utilisation de la table de référence pour déterminer un risque d'échec d'atterrissage pour un aéronef sur une piste d'atterrissage d'un aéroport, selon un premier mode de réalisation. La table de référence est construite comme expliqué ci-dessus en relation avec la Fig. 1.

Dans une étape 302, le système obtient des conditions envisagées à l'atterrissage. Les conditions envisagées à l'atterrissage sont exprimées par des valeurs correspondantes des M variables.

Dans une étape 304, le système recherche un jeu de conditions enregistré dans la table de référence le plus proche des conditions envisagées à l'atterrissage.

Dans une étape 306, le système récupère de la table de référence des valeurs attendues de moyenne et d'écart-type pour chaque paramètre de toucher au sol, qui ont été enregistrées en correspondance du jeu de conditions issu de l'étape 304.

Dans une étape 308, le système détermine un risque d'échec d'atterrissage pour l'aéronef sur la piste d'atterrissage de l'aéroport en question, en utilisant la moyenne et l'écart-type, pour chaque paramètre de toucher au sol, récupérés à l'étape 306.

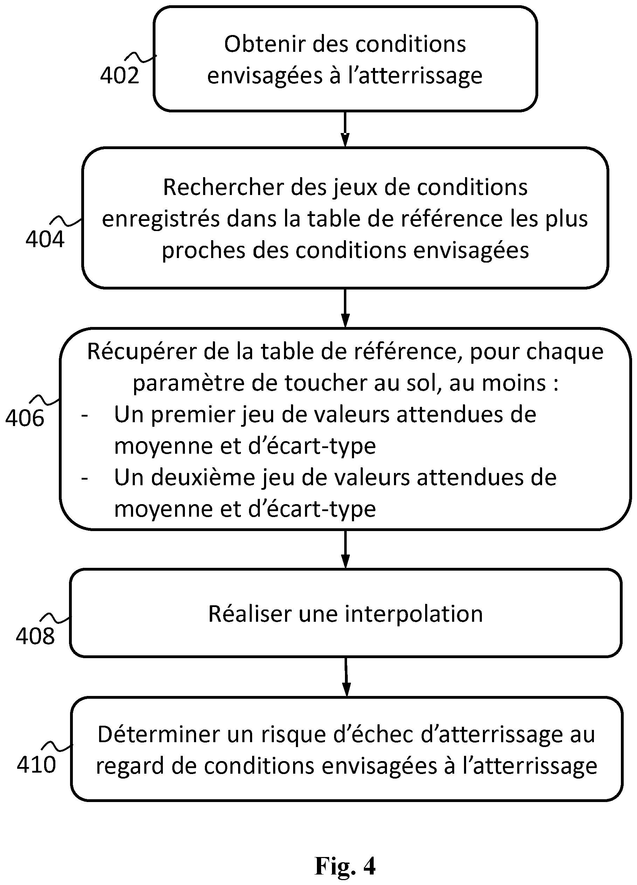

La **Fig. 4** illustre schématiquement un algorithme d'utilisation de la table de référence pour déterminer un risque d'échec d'atterrissage pour un aéronef sur une piste d'atterrissage d'un aéroport, selon un deuxième mode de réalisation. La table de référence est construite comme expliqué ci-dessus en relation avec la Fig. 1.

Dans une étape 402, le système obtient des conditions envisagées à l'atterrissage. Les conditions envisagées à l'atterrissage sont exprimées par des valeurs correspondantes des M variables.

Dans une étape 404, le système recherche des jeux de conditions enregistrés dans la table de référence qui sont les plus proches des conditions envisagées à l'atterrissage. Par exemple, le système recherche les deux jeux de conditions enregistrés dans la table de référence qui sont les plus proches des conditions envisagées à l'atterrissage.

Dans une étape 406, le système récupère de la table de référence, pour chaque paramètre de toucher au sol, au moins :
- un premier jeu de valeurs attendues de moyenne et d'écart-type ; et
- un deuxième jeu de valeurs attendues de moyenne et d'écart-type.

Le système récupère ainsi un jeu de valeurs attendues de moyenne et d'écart-type qui a été enregistré en correspondance de chaque jeu de conditions issu de l'étape 404.

Dans une étape 408, le système réalise une interpolation (par exemple, une interpolation linéaire) des jeux de valeurs attendues de moyenne et d'écart-type récupérés dans l'étape 406.

Dans une étape 410, le système détermine un risque d'échec d'atterrissage pour l'aéronef sur la piste d'atterrissage de l'aéroport en question, en utilisant la moyenne et l'écart-type, pour chaque paramètre de toucher au sol, qui résultent de l'interpolation réalisée à l'étape 408.

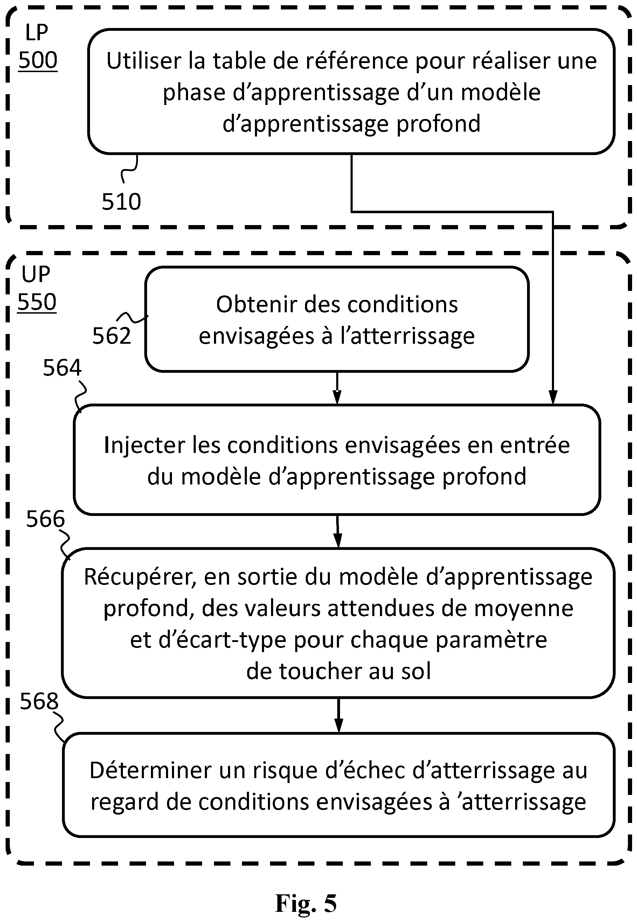

La **Fig. 5** illustre schématiquement un algorithme d'utilisation de la table de référence pour déterminer un risque d'échec d'atterrissage pour un aéronef sur une piste d'atterrissage d'un aéroport, selon un troisième mode de réalisation. La table de référence est construite comme expliqué ci-dessus en relation avec la Fig. 1.

L'algorithme de la Fig. 5 repose sur une utilisation d'un modèle d'apprentissage profond (« Deep Learning model » en anglais). Ainsi, l'algorithme est décomposé en deux phases : une phase d'apprentissage LP 500 (entraînement et validation) et une phase d'utilisation UP 550. Le modèle d'apprentissage profond est par exemple un réseau de neurones à 2 couches ayant une taille de 10 à 30 neurones.

Ainsi, dans une étape 510, le système utilise la table de référence pour réaliser la phase d'apprentissage du modèle d'apprentissage profond. L'apprentissage est tel que les conditions enregistrées dans la table de référence sont saisies en entrée du modèle d'apprentissage profond afin de prédire les valeurs correspondantes de moyenne et d'écart-type pour chaque paramètre de toucher au sol. A noter que, dans un mode de réalisation particulier, la table de référence utilisée est celle obtenue suite à l'analyse des relations de dépendance susmentionnée.

Une fois l'apprentissage terminé, le modèle d'apprentissage profond est utilisable pour déterminer le risque d'échec d'atterrissage pour l'aéronef sur la piste d'atterrissage de l'aéroport en question.

Ainsi, dans une étape 562, le système obtient des conditions envisagées à l'atterrissage. Les conditions envisagées à l'atterrissage sont exprimées par des valeurs correspondantes des M variables.

Dans une étape 564, le système injecte les conditions envisagées à l'atterrissage en entrée du modèle d'apprentissage profond.

Dans une étape 566, le système récupère en sortie du modèle d'apprentissage profond des valeurs attendues de moyenne et d'écart-type pour chaque paramètre de toucher au sol.

Dans une étape 568, le système détermine un risque d'échec d'atterrissage pour l'aéronef sur la piste d'atterrissage de l'aéroport en question, en utilisant la moyenne et l'écart-type, pour chaque paramètre de toucher au sol, qui ont été récupérés à l'étape 566.

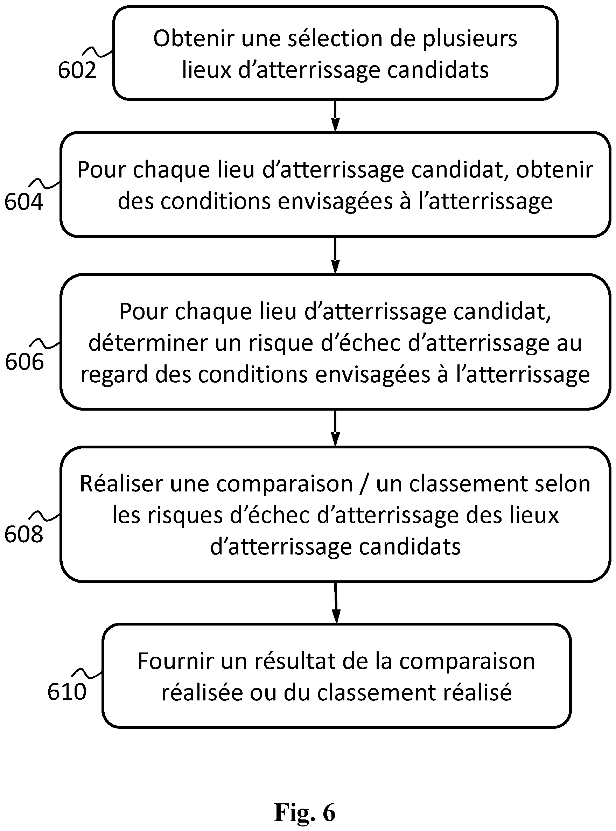

La **Fig. 6** illustre schématiquement un algorithme d'assistance au pilotage d'aéronef permettant d'effectuer une sélection de lieu d'atterrissage.

Dans une étape 602, le système obtient une sélection de plusieurs lieux d'atterrissage candidats. Selon un premier exemple, lors d'un déroutement de l'aéronef, l'avionique de l'aéronef détermine un ensemble de lieux d'atterrissage potentiels (aéroports de déroutement) dans un rayon prédéterminé de l'aéronef en vol, et l'indique au système. Selon un deuxième exemple, la sélection est faite par l'équipage de l'aéronef via une interface homme-machine du cockpit de l'aéronef.

Dans une étape 604, le système obtient, pour chaque lieu d'atterrissage candidat, des conditions envisagées à l'atterrissage. Les conditions envisagées à l'atterrissage sont exprimées par des valeurs correspondantes des M variables. Les conditions envisagées à l'atterrissage vont typiquement différer d'un lieu d'atterrissage à un autre.

Dans une étape 606, le système détermine, pour chaque lieu d'atterrissage candidat, un risque d'échec d'atterrissage au regard des contions envisagées à l'atterrissage (pour ledit lieu d'atterrissage candidat). La détermination du risque d'échec d'atterrissage est effectuée comme précédemment décrit, en utilisant la table de référence (éventuellement par le biais du modèle d'apprentissage profond susmentionné).

Dans une étape 608, le système réalise une comparaison, ou un classement, des lieux d'atterrissage candidats selon le risque d'échec d'atterrissage déterminé pour chacun desdits lieux d'atterrissage candidats.

Dans une étape 610, le système fournit un résultat de la comparaison réalisée ou du classement réalisé. Selon un premier exemple, le système affiche, sur un écran d'une interface homme-machine du cockpit de l'aéronef, le lieu d'atterrissage candidat qui présente le plus faible risque d'échec d'atterrissage. Selon un deuxième exemple, le système affiche, sur un écran d'une interface homme-machine du cockpit de l'aéronef, les lieux d'atterrissage candidats par ordre décroissant de risque d'échec d'atterrissage.

Dans un mode de réalisation particulier, le système effectue un filtrage de sorte à exclure tout lieu d'atterrissage candidat qui présente un risque d'échec d'atterrissage supérieur à un seuil TH prédéterminé représentatif d'un risque d'échec inacceptable. Par exemple, le seuil TH est fixé à 10⁻⁶ ou à 10⁻⁷.

Dans un mode de réalisation particulier, l'algorithme de la Fig. 6 est suivi d'opérations de pilotage de l'aéronef selon une trajectoire d'approche d'une piste d'atterrissage sélectionnée parmi plusieurs pistes d'atterrissages candidates en fonction des risques d'échec d'atterrissage obtenus pour lesdites pistes d'atterrissages candidates.

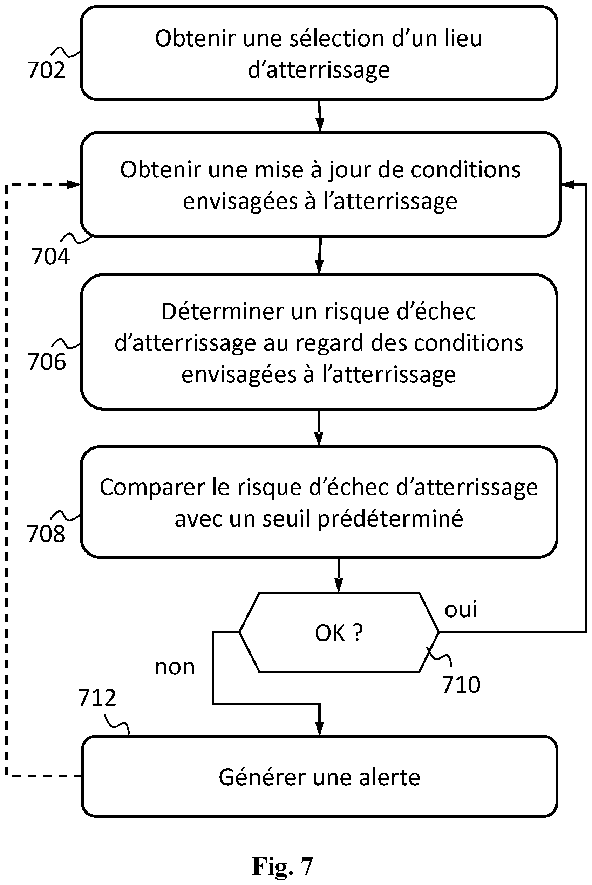

La Fig. 7 illustre schématiquement un algorithme d'assistance au pilotage d'aéronef permettant de surveiller une évolution de risque d'échec d'atterrissage à destination.

Dans une étape 702, le système obtient une sélection d'un lieu d'atterrissage. Selon un premier exemple, l'avionique de l'aéronef indique au système l'aéroport de destination de l'aéronef en vol. Selon un deuxième exemple, la sélection est faite par l'équipage de l'aéronef via une interface homme-machine du cockpit de l'aéronef.

Dans une étape 704, le système obtient une mise à jour de conditions envisagées à l'atterrissage sur le lieu d'atterrissage sélectionné. La mise à jour peut provenir de données de capteurs et/ou de calculateurs embarqués dans l'aéronef et/ou de données (e.g., météorologiques à destination) reçus par communication air/sol.

Dans une étape 706, le système détermine un risque d'échec d'atterrissage au regard des contions envisagées à l'atterrissage, pour ledit lieu d'atterrissage sélectionné. La détermination du risque d'échec d'atterrissage est effectuée comme précédemment décrit, en utilisant la table de référence (éventuellement par le biais du modèle d'apprentissage profond susmentionné).

Dans une étape 708, le système compare le risque d'échec d'atterrissage avec le seuil TH prédéterminé déjà mentionné.

Dans une étape 710, le système vérifie si le résultat de la comparaison indique que le risque d'échec d'atterrissage est inférieur au seuil prédéterminé. Si tel est le cas, le système se met en attente d'une nouvelle mise à jour des conditions envisagées à l'atterrissage dans l'étape 704 ; sinon, une étape 712 est effectuée.

Dans l'étape 712, le système génère une alerte. Selon un premier exemple, le système génère une alerte sonore et/ou visuelle par le biais d'une interface homme-machine du cockpit de l'aéronef. Selon un premier exemple, le système transmet un message d'alerte par communication air/sol.

## Revendications

1. Procédé de détermination d'un risque d'échec d'atterrissage d'un aéronef sur un lieu d'atterrissage, dans lequel un système sous forme de circuiterie électronique construit une table de référence comme suit :
- effectuer (102) une sélection d'un jeu de valeurs de M variables représentatives de conditions d'atterrissage indépendantes de turbulences potentielles à l'atterrissage ;
- réaliser (104) un nombre P de simulations en boucle fermée en appliquant des conditions de turbulences aléatoires selon un modèle prédéfini de turbulences, à partir du jeu de valeurs des M variables qui a été sélectionné ;
- calculer (106) une moyenne et un écart-type de paramètres de toucher au sol à partir des P simulations en boucle fermée ;
- compléter (108) la table de référence en ajoutant une ligne à la table de référence, chaque ligne stockant la moyenne et l'écart-type de chaque paramètre de toucher au sol, ainsi que le jeu de valeurs des M variables qui a permis d'obtenir ladite moyenne et ledit écart-type ;
- réitérer pour un nombre N de jeux de valeurs des M variables, les valeurs de chaque variable étant choisies de manière uniforme entre une valeur minimale et une valeur maximale de ladite variable ;
et le procédé étant tel qu'il comporte en outre :
- utiliser (112) la table de référence pour déterminer le risque d'échec d'atterrissage de l'aéronef sur le lieu d'atterrissage, au regard de conditions d'atterrissage envisagées, le risque d'échec d'atterrissage étant une probabilité qu'au moins un des paramètres de toucher au sol franchisse une limite autorisée pour ledit paramètre de toucher au sol.

2. Procédé selon la revendication 1, dans lequel utiliser la table de référence comporte :
- utiliser (510) la table de référence pour réaliser une phase d'apprentissage (500) d'un modèle d'apprentissage profond, l'apprentissage étant tel que les conditions enregistrées dans la table de référence sont saisies en entrée du modèle d'apprentissage profond afin de prédire les valeurs correspondantes de moyenne et d'écart-type pour chaque paramètre de toucher au sol ;
et dans une phase d'utilisation (550) du modèle d'apprentissage profond après la phase d'apprentissage (500) :
- obtenir (562) les conditions envisagées à l'atterrissage, exprimées par des valeurs correspondantes des M variables ;
- injecter (564) les conditions envisagées à l'atterrissage en entrée du modèle d'apprentissage profond ;
- récupérer (566) en sortie du modèle d'apprentissage profond des valeurs attendues de moyenne et d'écart-type pour chaque paramètre de toucher au sol ;
- déterminer (568) le risque d'échec d'atterrissage pour l'aéronef sur le lieu d'atterrissage, en utilisant la moyenne et l'écart-type, pour chaque paramètre de toucher au sol, récupérés.

3. Procédé selon la revendication 1, dans lequel utiliser la table de référence comporte :
- obtenir (302) les conditions envisagées à l'atterrissage, exprimées par des valeurs correspondantes des M variables ;
- rechercher (304) un jeu de conditions enregistré dans la table de référence le plus proche des conditions envisagées à l'atterrissage ;
- récupérer (306) de la table de référence des valeurs attendues de moyenne et d'écart-type pour chaque paramètre de toucher au sol, qui ont été enregistrées en correspondance du jeu de conditions le plus proche des conditions envisagées à l'atterrissage ; et
- déterminer (308) le risque d'échec d'atterrissage pour l'aéronef sur le lieu d'atterrissage, en utilisant la moyenne et l'écart-type, pour chaque paramètre de toucher au sol, récupérés.

4. Procédé selon la revendication 1, dans lequel utiliser la table de référence comporte :
- obtenir (402) les conditions envisagées à l'atterrissage, exprimées par des valeurs correspondantes des M variables ;
- rechercher (404) des jeux de conditions enregistrés dans la table de référence qui sont les plus proches des conditions envisagées à l'atterrissage ;
- récupérer (406) un jeu de valeurs attendues de moyenne et d'écart-type qui a été enregistré en correspondance de chaque jeu de conditions parmi lesdits jeux de conditions les plus proches des conditions envisagées à l'atterrissage ;
- réaliser (408) une interpolation des jeux de valeurs attendues de moyenne et d'écart-type récupérés ; et
- déterminer (410) un risque d'échec d'atterrissage pour l'aéronef sur le lieu d'atterrissage, en utilisant la moyenne et l'écart-type, pour chaque paramètre de toucher au sol, qui résultent de l'interpolation réalisée.

5. Procédé selon l'une quelconque des revendications 1 à 4, comportant en outre :
- éliminer des conditions qui ont le moins d'influence sur les paramètres de toucher au sol par rapport aux autres conditions, pour réduire N à Q, et
- remplacer la table de référence obtenue avec les N jeux de valeurs des M variables par une nouvelle table de référence obtenue avec les Q jeux de valeurs des M variables.

6. Procédé selon l'une quelconque des revendications 1 à 4, comportant en outre :
- analyser des relations de dépendance des paramètres de toucher au sol avec les M variables ;
- déterminer quelle combinaison linéaire des M variables influence le plus les paramètres de toucher au sol,
- remplacer la table de référence obtenue avec les N jeux de valeurs des M variables par une nouvelle table de référence obtenue avec Q jeux de la combinaison linéaire des M variables, et dans lequel la table de référence est utilisée en appliquant la même combinaison linéaire sur les conditions envisagées à l'atterrissage.

7. Procédé selon l'une quelconque des revendications 1 à 4, comportant en outre :
- déterminer quelles variables parmi les M variables influencent le plus les paramètres de toucher au sol ;
- remplacer la table de référence obtenue avec les N jeux de valeurs des M variables sélectionnés de manière uniforme par une nouvelle table de référence obtenue en augmentant un panel de valeurs des variables qui influencent le plus les paramètres de toucher au sol et en diminuant un panel de valeurs des variables qui influencent le moins les paramètres de toucher au sol.

8. Procédé selon l'une quelconque des revendications 1 à 7, implémenté dans le cadre d'une assistance au pilotage d'aéronef, pour effectuer une sélection de lieu d'atterrissage parmi des lieux d'atterrissage candidats.

9. Procédé selon l'une quelconque des revendications 1 à 7, implémenté dans le cadre d'une assistance au pilotage d'aéronef, pour surveiller une évolution de risque d'échec d'atterrissage à destination.

10. Système configuré pour déterminer un risque d'échec d'atterrissage d'un aéronef sur un lieu d'atterrissage, le système étant sous forme de circuiterie électronique, la circuiterie électronique étant configurée pour construire une table de référence comme suit :
- effectuer (102) une sélection d'un jeu de valeurs de M variables représentatives de conditions d'atterrissage indépendantes de turbulences potentielles à l'atterrissage ;
- réaliser (104) un nombre P de simulations en boucle fermée en appliquant des conditions de turbulences aléatoires selon un modèle prédéfini de turbulences, à partir du jeu de valeurs des M variables qui a été sélectionné ;
- calculer (106) une moyenne et un écart-type de paramètres de toucher au sol à partir des P simulations en boucle fermée ;
- compléter (108) la table de référence en ajoutant une ligne à la table de référence, chaque ligne stockant la moyenne et l'écart-type de chaque paramètre de toucher au sol, ainsi que le jeu de valeurs des M variables qui a permis d'obtenir ladite moyenne et ledit écart-type ;
- réitérer pour un nombre N de jeux de valeurs des M variables, les valeurs de chaque variable étant choisies de manière uniforme entre une valeur minimale et une valeur maximale de ladite variable ;
et la circuiterie électronique étant en outre configurée pour :
- utiliser (112) la table de référence pour déterminer le risque d'échec d'atterrissage de l'aéronef sur le lieu d'atterrissage, au regard de conditions d'atterrissage envisagées, le risque d'échec d'atterrissage étant une probabilité qu'au moins un des paramètres de toucher au sol franchisse une limite autorisée pour ledit paramètre de toucher au sol.
